**Europäisches Patentamt**

**European Patent Office**

**Office européen des brevets**

(19)

(11) Veröffentlichungsnummer : **0 397 066 B1**

(12)

# EUROPÄISCHE PATENTSCHRIFT

(45) Veröffentlichungstag der Patentschrift :
**04.11.92 Patentblatt 92/45**

(51) Int. Cl.$^5$ : **F26B 15/12, F26B 25/20**

(21) Anmeldenummer : **90108501.9**

(22) Anmeldetag : **07.05.90**

(54) **Vorrichtung zur Durchlauftrocknung von beidseitig beschichteten Platten.**

(30) Priorität : **10.05.89 DE 3915278**

(43) Veröffentlichungstag der Anmeldung :
**14.11.90 Patentblatt 90/46**

(45) Bekanntmachung des Hinweises auf die
Patenterteilung :
**04.11.92 Patentblatt 92/45**

(84) Benannte Vertragsstaaten :
**AT BE CH DE FR GB IT LI**

(56) Entgegenhaltungen :
**EP-A- 0 130 625**
**EP-A- 0 156 236**
**DE-A- 2 646 111**
**DE-A- 3 014 891**
**DE-C- 3 421 631**
**GB-A- 744 343**
**US-A- 2 674 809**

(73) Patentinhaber : **HOECHST
AKTIENGESELLSCHAFT
Postfach 80 03 20
W-6230 Frankfurt am Main 80 (DE)**

(72) Erfinder : **Hultzsch, Günter, Dr. Dipl.-Chem.
Drusus-Strasse 61
W-6200 Wiesbaden (DE)**
Erfinder : **Idstein, Hermann
Schiller-Strasse 39
W-6227 Oestrich-Winkel (DE)**
Erfinder : **Nies, Reinhard, Dipl.-Ing.
Borkenweg 14
W-2000 Hamburg 14 (DE)**

## Beschreibung

Die Erfindung betrifft eine Vorrichtung zur Durchlauftrocknung von beidseitig beschichteten Platten, mit einer Anzahl von Transportwalzen, die die Platten in einer Ebene durch eine Trocknungszone, in der Wärmequellen oberhalb der Transportwalzen angeordnet sind, und anschließend durch eine Kühlzone führen.

Aus der EP-A- 0 130 625 ist eine Vorrichtung zum Wärmetrocknen bedruckter oder gefärbter Bahnen bekannt, die zwei Heizwalzen und zwei Kühlwalzen aufweist. Die zu trocknenden Bahnen umschlingen teilweise die Heiz- und die Kühlwalzen und sind nicht in einer Ebene durch die Trocknungs- und Kühlzone hindurchgeführt. Die Vorrichtung umfaßt drei Kammern, wobei in der ersten Kammer eine kontaktlose Wärmebehandlung der zu trocknenden Bahnen mittels eines gasförmigen Mediums bei 300 °C erfolgt, in der zweiten Kammer eine Kontaktbeheizung durch die Heizwalzen bei etwa 230 °C und in der dritten Kammer eine Kontaktkühlung durch die Kühlwalzen bei etwa 25 °C stattfindet.

Zur Herstellung von Leiterbahnzügen auf Leiterplatten nach dem Fotodruck-Verfahren werden kupferlaminierte Isolationsmaterialien zunächst mit einer fotoempfindlichen Schicht, dem Ätz- oder Galvanoresist, versehen. In einem weiteren Schritt können die strukturierten Leiterbahnzüge mit fotoempfindlichen Lötstopplacken überzogen werden, die einerseits die nicht freigelegten Leiterbahnen im Lötprozeß vor dem flüssigen Lot und andererseits beim Belasten mit Strom, insbesondere bei hoher Luftfeuchte, vor Korrosion schützen.

Diese fotoempfindlichen Schichten werden entweder als Trockenfilmresist durch Laminieren oder als Fotolacke durch Beschichten mit anschließender Trocknung aufgebracht. Als Beschichtungsverfahren für Leiterplatten sind das Tauchziehen, der Siebdruck, der Walzenantrag, das Vorhanggießen oder das elektrostatische Sprühverfahren im Einsatz.

Zum überwiegenden Teil tragen die Leiterplatten auf beiden Seiten Leiterbahnen, die durch fotochemische Verfahren hergestellt werden und durch chemisch-galvanische Metallisierung miteinander verbunden werden.

Als "Leiterplatte" soll hier sowohl das kupferkaschierte Isolationsmaterial als auch die bereits strukturierte Leiterplatte verstanden werden.

Zum überwiegenden Teil bestehen die fotoempfindlichen flüssigen Fotolacke aus strahlungsempfindlichen Komponenten, Bindemitteln, Sensibilisatoren, Lackhilfsmitteln sowie organischen Lösemitteln. Vor der Belichtung, die in der Regel im Kontakt mit Film-Vorlagen von beiden Seiten aus erfolgt, muß der Fotolack getrocknet werden, damit die Vorlagen beim Belichten nicht an den Fotolackschichten kleben.

Die Vorlage besteht im allgemeinen aus einem Polyesterfilm, es kann sich dabei aber auch um ein Glaswerkzeug handeln.

Die Trocknung des fotosensiblen Flüssiglackes erfolgt nach dem Beschichten durch Erwärmen der Lackschicht auf ca. 70° bis 120 °C. Dabei verdampft einerseits das Lösemittel; andererseits werden die Lackschichten, die Reaktivkomponenten, die z.B. Monomere oder Diazoniumsalze enthalten, beim Erwärmen wieder weich, da die Trocknungstemperaturen überwiegend oberhalb der Erweichungstemperaturen der Komponenten liegen. Damit sind diese bereits getrockneten Schichten beim Erwärmen weiterhin empfindlich gegen mechanische Berührung. Spezielle Lacke, insbesondere die fotosensiblen Lötstoppmasken, erweichen so leicht, daß beispielsweise im Belichtungsrahmen, in dem ohne weiteres Temperaturen von 35° bis 38 °C entstehen, und in dem die Platten im Vakuum mit der Filmvorlage kontaktiert werden, bereits Verarbeitungsschwierigkeiten auftreten können.

Als allgemeine Beschichtungstechniken haben sich einseitige Auftragsverfahren, wie der Siebdruck, das elektrostatische Sprühverfahren sowie Vorhanggießen durchgesetzt. Dabei werden die Platten, ebenso wie in der Vorreinigung und der Belichtung, horizontal transportiert.

So ist aus der DE-OS 17 72 976 ein fotomechanisches Verfahren zur Herstellung von Leiterplatten mit durchkaschierten Bohrungen bekannt, bei dem die lichtempfindliche Schicht, auf welche das später auszuätzende Flächenmuster zunächst fotografisch übertragen werden soll, mittels eines elektrostatischen Lackierverfahrens aufgebracht wird.

Für beidseitig lackierte Leiterplatten stellt sich die Forderung, sie so herzustellen, daß beim Trocknen keine Markierungen oder Verklebungen an der Oberfläche der zuerst lackierten Plattenseite beim Trocknen der anderen Plattenseite entstehen. Üblicherweise werden die Leiterplatten zunächst auf einer Seite lackiert und vorgetrocknet und dann nach Wenden auf der zweiten Seite in der gleichen oder einer zweiten Anlage lackiert und zuletzt beide Seiten zu Ende getrocknet.

Eine Trocknungsmöglichkeit besteht darin, die Platten in geeignete Gestelle zu legen und im Warmluftofen zu trocknen. Dazu müssen die Gestelle in der Regel manuell bestückt werden. An den Plattengestellen gibt es Auflagepunkte der Platten, an denen es auch zum Verkleben kommen kann. Eine besondere Schwierigkeit bereitet es, in diesen Gesteilen Platten unterschiedlicher Formate zu trocknen; hierzu müssen Gestelle unterschiedlicher oder variabler Größe eingesetzt werden.

Eine andere Trocknungsmöglichkeit bei der beidseitigen Lackierung ergibt sich durch Horizontaldurchlauföfen mit V-förmigen Bändern für den Plattentransport. Auf diesen V-förmigen Bändern liegen die lackierten Platten nur mit den Kanten auf. Da allerdings das Band beim Durchlauf durch den Trockner aufgewärmt wird, erweicht der Lack bevorzugt an diesen Auflagepunkten, was zum Verkleben bzw. zur Verunreinigung des Bandes führen kann. Diese V-förmigen Bänder sind ferner nicht geeignet zum Trocknen flexibler oder biegsamer Leiterplatten, wie sie als Innenlagen zur Herstellung von Multilayerverbunden eingesetzt werden, da derartige Leiterplatten sich durchbiegen bzw. durchhängen.

Anstelle eines V-förmigen Bandes können auch entsprechend gebogene Bügel eingesetzt werden. Die Kontaktfläche ist dann kleiner, aber der Auflagedruck höher. Werden Formate stark unterschiedlicher Größe benutzt, so muß entweder der Abstand der schräggestellten Bänder oder der Winkel verstellt werden. Dies ist insbesondere beim Trocknen mit IR-Strahlern wesentlich, da der Abstand Strahler/Platte möglichst konstant sein muß.

In einem weiteren Verfahren zum Trocknen beidseitig lackierter Platten werden Trockner mit Kluppenkettentransport der Platten eingesetzt. Auch hier hinterlassen die Kluppen Abdrücke, da sie sich aufwärmen und in die Lackschicht eingreifen. Dabei können Lackteilchen an den Kluppen hängenbleiben, die Anlaß zu Verunreinigungen im Trockner geben. Ferner muß die Anpassung an die Plattengröße sehr sorgfältig erfolgen. Zum Transport flexibler Platten müssen die Ketten die Platten zusätzlich gespannt halten.

Zur Trocknung bei der Leiterplattenherstellung werden auch Horizontaldurchlauföfen eingesetzt, in denen die Platten auf Ketten mit seitlich eingepaßten Stiften gefördert werden. Dabei wird die Oberseite mit IR-Strahlern erwärmt und die Unterseite gleichzeitig mit einem Luftstrahl gekühlt. Dies erfolgt in der Regel, um die an der Unterseite bereits bestückten Bauelemente vor Überhitzung zu schützen. Diese Kühlluft verhindert allerdings nicht, daß die gesamte Kette sowie die Transportstifte im Durchlauf aufgeheizt werden und dabei die Lackierung der Unterseite beschädigt werden kann.

Die Verprägung des Lackes an der Plattenunterseite und die Verschmutzung der Transportsysteme können vermieden werden, wenn die Beschichtung nicht bis zum Plattenrand erfolgt. Dies erfordert besondere Maßnahmen zur Begrenzung der Lackierung, die beim Ändern des Plattenformats jeweils angepaßt werden müssen. Damit die Lackierung innerhalb weniger Millimeter der Randzone begrenzt werden kann, müssen die Platten ferner exakt ausgerichtet in einer Linie und kantengerade durch die Beschichtungsanlage laufen. Bei häufigem Formatwechsel, wie er bei der Leiterplatten-Herstellung unvermeidlich ist, erfordert dies großen Steuerungsaufwand.

Bekannt sind ferner Kühlbänder zur Abkühlung von geschmolzenen Harzen oder Polymeren, wobei die Schmelze auf ein Endlos-Metallband gegossen wird und das Endlosband von der Unterseite mittels Walzen, Luftstrahl oder Flüssigkeiten, z.B. auch flüssigem Stickstoff, gekühlt wird. Dabei ist es aber nicht entscheidend, ob die erstarrte Schmelze von der Bandoberfläche verprägt wird oder nicht. Denkbar wäre auch, ein gekühltes Transportband zur Leiterplattentrocknung einzusetzen. Allerdings ist die Herstellung derartiger Endlos-Metallbänder relative teuer, und es ist schwierig, das Band ständig im Kontakt mit einer Kühlfläche zu halten. Erfolgt dies nicht, kann sich das Band wegen seiner geringen Wärmekapazität schnell aufheizen, was wieder zu Lackverklebungen führt.

Aufgabe der Erfindung ist es, eine Vorrichtung zur Durchlauftrocknung von beidseitig beschichteten Platten der eingangs beschriebenen Art so zu verbessern, daß sowohl starre als auch flexible Platten unterschiedlicher Formate im Durchlauf getrocknet werden können, ohne daß die Lackschicht beschädigt und die Transportvorrichtung für die Platten verschmutzt wird.

Diese Aufgabe wird erfindungsgemäß dadurch gelöst, daß die einzelne Transportwalze sowohl in der Trocknungs- als auch in der Kühlzone als innen hohle Kühlwalze ausgebildet ist, daß die an beiden Stirnflächen der Transportwalze anschließenden Wellenzapfen innen hohl sind und daß jeder Wellenzapfen mit einem Drehverteiler verbunden ist, der an eine Ab- bzw. Zuleitung für das Kühlmedium angeschlossen ist.

Die weitere Ausgestaltung der Vorrichtung ergibt sich aus den Merkmalen der Patentansprüche 2 bis 9.

Die Erfindung wird im folgenden anhand der Zeichnungen näher erläutert. Es zeigen:

Fig. 1 eine schematische Schnittansicht einer Trocknungsvorrichtung mit horizontal ausgerichteten Transportwalzen für beschichtete Platten nach der Erfindung,

Fig. 2 eine perspektivische Ansicht einer Transportwalze und weiterer Elemente der Trocknungsvorrichtung,

Fig. 3 eine Ansicht einer weiteren Transportvorrichtung der Trocknungsvorrichtung, und

Fig. 4 in perspektivischer Darstellung ein Detail der Transportvorrichtung nach Figur 3.

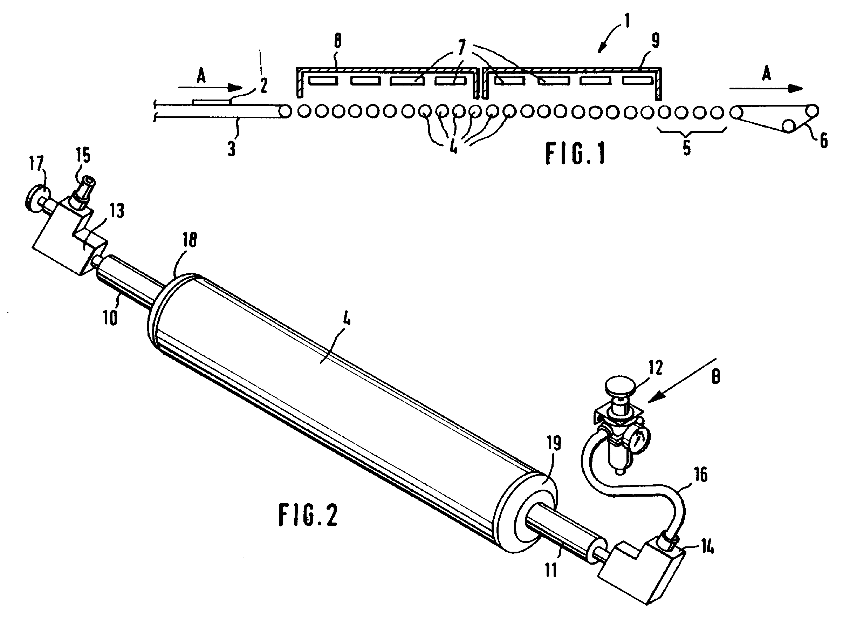

Eine in Figur 1 gezeigte Trocknungsvorrichtung 1 umfaßt zwei Trocknungszonen 8 und 9, die jeweils von einem nach unten offenen Gehäuse umgeben sind. Die Gehäuse können auch geschlossen sein, z.B. um den Eintritt von Staub aus dem umgebenden Raum in die Trocknungszonen zu verhindern. In jeder Trocknungszone 8 bzw. 9 befindet sich eine Anzahl von Wärmequellen 7, beispielsweise IR-Dunkelstrahler, die nach unten hin abstrahlen. Unterhalb der Trocknungszonen 8 und 9 befinden sich Transportwalzen 4, die parallel zueinander und horizontal angeordnet sind.

Eine beschichtete Platte 2 wird in Transportrichtung A auf einem Transportband 3 der Trocknungsvorrichtung 1 zugeführt. Die Platte 2 wird von dem Transportband 3 an die Transportwalzen 4 der Transportvorrichtung übergeben und von diesen horizontal durch die Trocknungsvorrichtung 1 hindurchgeführt. Nach dem Austritt aus der, in Transportrichtung A hinten liegenden Trocknungszone 9 wird die Platte 2 durch eine Kühlzone 5 geführt, die kürzer als jede der beiden Trocknungszonen 8, 9 ist und im wesentlichen aus Transportwalzen 4 besteht, die gekühlt werden. Nach der Kühlzone 5 erfolgt die Übergabe der Platte 2 auf ein endlos umlaufendes geschlossenes Transportband 6.

Die Platten 2 werden somit horizontal auf den von innen gekühlten Transportwalzen 4 durch die Trocknungsvorrichtung 1 transportiert, und zwar mit der frisch lackierten Seite nach oben. Die Rückseite kann unlackiert oder lackiert und vorgetrocknet sein.

Die auf der Plattenoberseite aufgetragenen Schichten können durch Warmluft, z.B. aus Düsen, oder, wie schon erwähnt, durch Infrarotstrahlung, z.B. durch sogenannte IR-Dunkelstrahler, oder durch eine Kombination von Düsenwarmluft und Infrarotstrahlern getrocknet werden. Zur Trocknung bzw. Härtung der Lacke können ferner auch andere Strahlungsquellen, bei denen Wärme entsteht, wie z.B. UV-Strahler, eingesetzt werden.

In Figur 2 ist eine Transportwalze 4 mit zusätzlichen Elementen perspektivisch dargestellt. Die Transportwalze 4 ist als innen hohle Kühlwalze ausgebildet, und an ihren beiden Stirnflächen 18, 19 schließen innen hohle Wellenzapfen 10 und 11 an. Jeder dieser Wellenzapfen 10 und 11 ist mit einem Drehverteiler 13 bzw. 14 verbunden, die es ermöglichen, daß sich die Wellenzapfen 10 und 11 ohne Dichtungsverluste drehen können. Der Drehverteiler 14 ist mit einem Druckregler 12 durch eine Zuleitung 16 verbunden. Dem Druckregler 12 wird das Kühlmedium in Durchströmrichtung B zugeführt. Der Drehverteiler 13 ist mit einer Drossel 17 ausgestattet, die es ermöglicht, den Durchfluß des Kühlmediums zu regeln. Von dem Drehverteiler 13 geht eine Ableitung 15 für das Kühlmedium ab. Als Gas- oder flüssiges Kühlmedium kann Luft bzw. Wasser oder ein spezielles Kühlmittel aus Wasser, Schmierzusatz und die Alterung des Wassers verzögerndem Zusatz eingesetzt werden. Auch können nichtwäßrige Kühlmittel, wie z.B. organische Lösemittel, zum Einsatz kommen. Das Kühlmittel kann dabei im geschlossenen Kreislauf durch die Transportwalzen 4 hindurchgeführt werden, wobei dann die Wärme aus dem Kühlmittel durch ein Kühlaggregat oder einen Wärmeaustauscher abgeführt wird. Ebenso ist es möglich, das Kühlmittel im offenen Durchfluß durch die Transportwalzen 4 hindurchströmen zu lassen.

Um eine gute Wärmeableitung zu erhalten, sind die Walzenoberflächen metallisch, bevorzugt auch wärmereflektierend, gestaltet und bestehen beispielsweise aus Aluminium oder anderen Metallen. Durch eine hohe Wärmereflexion wird erreicht, daß die Wärmeaufnahme der Walzen nur gering ist. Dementsprechend kann dann mit einer geringen Kühlleistung gearbeitet werden.

Die Walzenoberfläche kann auch sowohl mit einem lackabstoßenden Überzug, z.B. aus fluorierten Kohlenwasserstoffen, Silicon-Polymeren oder anderen geeigneten Kunststoffen, als auch mit anorganischen Schichten, z.B. Aluminiumoxid, überzogen sein.

Die Transportwalzen sind in der horizontalen Ebene so angeordnet, daß sowohl starre als auch flexible Leiterplatten, z.B. für Multilayer-Innenlagen, oder auch metallisierte Folien transportiert werden können. Dabei entspricht der Abstand zweier Transportwalzen der Hälfte der kleinsten Formatlänge oder weniger. Die Transportwalzen besitzen alle gleichen Außendurchmesser und werden z.B. über ein Kettentransportsystem angetrieben. Die Drehgeschwindigkeit ist variabel, um den Plattendurchlauf bzw. Plattendurchsatz zu regeln.

In der Transportvorrichtung 1 mit den horizontal und parallel angeordneten Transportwalzen 2 lassen sich alle Arten von Platten 2 trocknen.

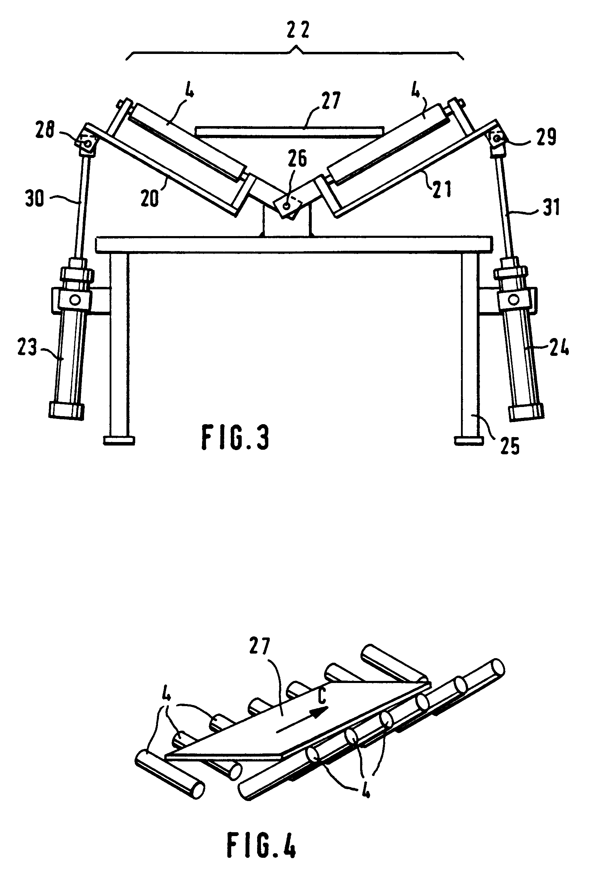

Für starre Leiterplatten wird eine V-förmige Transportvorrichtung 22, wie sie in den Figuren 3 und 4 gezeigt ist und entsprechend der Formatgröße verstellbar ist, bevorzugt.

Die V-förmige Transportvorrichtung 22 besteht aus zwei Plattenrahmen 20, 21, auf denen die Transportwalzen 4, zueinander parallel, auf jedem Plattenrahmen angeordnet sind. Die Neigung der Plattenrahmen 20, 21, die um eine gemeinsame Drehachse 26 verschwenkbar sind, ist mit Hilfe von Pneumatikzylindern 23, 24 verstellbar. Diese Pneumatikzylinder 23, 24 sind seitlich und nahezu senkrecht an einem Grundgestell 25 der Transportvorrichtung 22 angebracht. Jeder der beiden Pneumatikzylinder 23, 24 ist mit dem äußeren Ende seiner Kolbenstange 30 bzw. 31 an der Unterseite des zugehörigen Plattenrahmens 20 bzw. 21 in einem Anlenkpunkt 28 bzw. 29 schwenkbar angelenkt. Die Drehachse 26 ist auf einer horizontalen Fläche des Grundgestells 25 mittig angeordnet. Durch die V-förmige Ausgestaltung der Transportvorrichtung 22 wird erreicht, daß nur die unteren Kanten einer Leiterplatte 27, die in Richtung des Pfeils C in Figur 4 transportiert wird, in Berührung mit den Transportwalzen 4 stehen.

Während in herkömmlichen Warmluft- oder IR-Durchlauföfen während des Transportes die Leiterplattenunterseite nahezu die gleiche Temperatur wie die Plattenoberseite annimmt, wird in den Trocknungsvorrichtungen nach der Erfindung ein Teil der Wärme von der Plattenunterseite durch die als Kühlwalzen wirkenden Transportwalzen abgeführt und damit die Wärmebelastung des Lackes auf der Unterseite erheblich reduziert.

Beispielsweise wird in einer Infrarot-Trocknungsvorrichtung mit Teflontransportband, zwischen Plattenober- und -unterseite von beidseitig mit 35 μm starkem Kupfer kaschierten 1,5 mm dicken Platten aus Epoxyharz-Isolationsmaterialien, bei 80 °C Plattentemperatur, eine Differenz von 5° bis 8 °C gemessen. Im Vergleich dazu beträgt, unter sonst gleichen Bedingungen, die Temperaturdifferenz in einer Infrarot-Trocknungsvorrichtung nach der Erfindung zwischen Ober- und Unterseite der Platten 19° bis 25 °C.

Dadurch, daß die in der Trocknungsvorrichtung angeordneten Transportwalzen 4 sich während des Betriebes nicht aufheizen, wird an den Kontaktstellen der Walzen mit der Plattenunterseite Wärme nicht zugeführt, sondern stattdessen wird Wärme entzogen. Wird soviel abgeführt, daß die Oberflächentemperatur der Unterseitenlackierung unterhalb des Erweichungsbereiches des Lackes bleibt, wird verhindert, daß der Lack an den Transportwalzen klebt, bzw. daß Verprägungen auf der bereits lackierten Seite auftreten können. Unter Erweichungsbereich ist der Temperaturbereich zu verstehen, in welchem eine Lackschicht, unter dem Eigengewicht der Platte auf einer Metallwalzenoberfläche aufliegend, innerhalb weniger Sekunden noch keine Markierung bzw. Verprägung zeigt. Die erforderliche Walzentemperatur hängt von der aufgebrachten Wärmemenge und der Durchlaufgeschwindigkeit der Platten ab. Bevorzugt werden Walzenoberflächentemperaturen von +5° bis +30 °C. Mit Lacken geringer Thermoplastizität kann auch bei höheren Temperaturen gearbeitet werden.

Die nach der hinteren Trocknungszone 9 außerhalb des Heizbereiches angeordnete Kühlzone 5 dient zur schnelleren Abkühlung dr Platten 2. Dies ist in der Regel erforderlich, um die Platten nach dem Trocknen mittels Bänder, Riemen oder ähnlichem, an andere Stationen, wie z.B. Belichtungssysteme oder Stapelvorrichtungen, sofort weitertransportieren zu können. Der Abkühlvorgang kann durch Anblasen mit Luft, von der Ober- oder Unterseite, beschleunigt werden.

## Patentansprüche

1. Vorrichtung zur Durchlauftrocknung von beidseitig beschichteten Platten, mit einer Anzahl von Transportwalzen, die die Platten in einer Ebene durch eine Trocknungszone, in der Wärmequellen oberhalb der Transportwalzen angeordnet sind, und anschließend durch eine Kühlzone führen, dadurch gekennzeichnet, daß die einzelne Transportwalze (4) sowohl in der Trockungs- (8, 9) als auch in der Kühlzone (5) als innen hohle Kühlwalze ausgebildet ist, daß die an beiden Stirnflächen (18, 19) der Transportwalze anschließenden Wellenzapfen (10; 11) innen hohl sind und daß jeder Wellenzapfen (10; 11) mit einem Drehverteiler (13; 14) verbunden ist, der an eine Ab- bzw. Zuleitung (15 bzw. 16) für ein Kühlmittel angeschlossen ist.

2. Vorrichtung nach Anspruch 1, dadurch gekennzeichnet, daß in der Zuleitung (16) zu dem Drehverteiler (14) ein Druckregler (12) angeordnet ist.

3. Vorrichtung nach Anspruch 1, dadurch gekennzeichnet, daß der Drehverteiler (10), an den die Ableitung (15) anschließt, eine Drossel (17) zum Regeln des Durchflusses des Kühlmittels enthält.

4. Vorrichtung nach Anspruch 1, dadurch gekennzeichnet, daß die Transportwalzen (4) in einer horizontalen Ebene parallel zueinander angeordnet sind.

5. Vorrichtung nach Anspruch 1, dadurch gekennzeichnet, daß die Transportwalzen (4) auf zwei Plattenrahmen (20, 21) zueinander parallel auf jedem Plattenrahmen angeordnet sind, und daß die beiden Plattenrahmen (20, 21) deren Neigung zueinander verstellbar ist, eine V-förmige Transportvorrichtung (22) mit einer gemeinsamen Drehachse (26) bilden.

6. Vorrichtung nach Anspruch 5, dadurch gekennzeichnet, daß jeder der beiden Plattenrahmen (20, 21) mit Hilfe eines Pneumatikzylinders (23, 24) verstellbar ist, der seitlich und nahezu senkrecht an einem Grundgestell (25) angebracht ist.

7. Vorrichtung nach Anspruch 6, dadurch gekennzeichnet, daß jeder der beiden Pneumatikzylinder (23, 24) mit dem äußeren Ende seiner Kolbenstange (30, 31) an der Unterseite des zugehörigen Plattenrahmens (20, 21) in einem Anlenkpunkt (28; 29) schwenkbar angelenkt ist.

8. Vorrichtung nach Anspruch 1, dadurch gekennzeichnet, daß die Oberflächen der Transportwalzen (4) metallisch sind, um eine hohe Wärmereflexion zu erreichen.

9. Vorrichtung nach Anspruch 1, dadurch gekennzeichnet, daß das Kühlmittel Luft, Wasser, ein Kühlmittel aus Wasser, Schmierzusatz und die Alterung des Wassers verzögerndem Zusatz oder ein organisches Lösemittel ist.

## Revendications

1. Dispositif de séchage continu de plaquettes revêtues sur les deux faces, comprenant un certain nombre de cylindres de transport qui guident les plaquettes dans un plan à travers une zone de séchage, dans laquelle des sources de chaleur sont disposées au-dessus des cylindres de transport, puis à travers une zone de refroidissement, caractérisé en ce que chaque cylindre de transport (4), tant de la zone de séchage (8, 9) que de la zone de refroidissement (5), est réalisé sous la forme d'un cylindre de refroidissement intérieurement creux, en ce que les tourillons (10, 11) solidaires des deux faces frontales (18, 19) du cylindre de transport sont intérieurement creux et en ce que chaque tourillon (10,11) est relié à un joint tournant (13, 14) qui est raccordé à une conduite (15, 16) respectivement d'évacuation ou d'amenée d'un agent de refroidissement.

2. Dispositif suivant la revendication 1, caractérisé en ce qu'un régulateur de pression (12) est disposé dans la tuyauterie d'amenée (16) conduisant au joint tournant (14).

3. Dispositif suivant la revendication 1, caractérisé en ce que le joint tournant auquel la tuyauterie d'évacuation (15) est raccordée contient un organe d'étranglement (17) servant à régler le débit d'agent de refroidissement.

4. Dispositif suivant la revendication 1, caractérisé en ce que les cylindres de transport (4) sont disposés parallèlement entre eux dans un plan horizontal.

5. Dispositif suivant la revendication 1, caractérisé en ce que les cylindres de transport (4) sont disposés sur deux cadres à plaquettes (20, 21) en étant parallèles entre eux sur chaque cadre et en ce que les deux cadres à plaquettes (20, 21), dont l'inclinaison relative est réglable, constituent un dispositif de transport (22) en V comportant un axe commun de rotation (26).

6. Dispositif suivant la revendication 5, caractérisé en ce que chacun des deux cadres à plaquettes (20, 21) est réglable au moyen d'un vérin pneumatique (23, 24) qui est monté latéralement et d'une manière pratiquement verticale sur un bâti de base (25).

7. Dispositif suivant la revendication 6, caractérisé en ce que chacun des deux vérins pneumatiques (23, 24) est articulé de manière pivotante, par l'extrémité extérieure de sa tige de piston (30, 31) et en un point d'articulation (28, 29), sur la face inférieure du cadre à plaquettes (20, 21) associé.

8. Dispositif suivant la revendication 1, caractérisé en ce que les surfaces des cylindres de transport (4) sont métalliques afin de permettre une réflexion élevée de la chaleur.

9. Dispositif suivant la revendication 1, caractérisé en ce que l'agent de refroidissement est de l'air, de l'eau, un agent de refroidissement formé d'eau, d'un additif de lubrification et d'un additif retardant le vieillissement de l'eau, ou un solvant organique.

## Claims

1. An apparatus for continuously drying boards coated on both sides, comprising a number of conveyor rollers which first convey the boards along a plane through a drying zone where heat sources are arranged above the conveyor rollers and then through a cooling zone, wherein each conveyor roller (4), both in the drying zone (8, 9) and in the cooling zone (5) is designed as an inwardly hollow cooling roller, wherein the shaft journals (10; 11) adjoining both end faces (18, 19) of the conveyor roller (4) are inwardly hollow and wherein every shaft journal (10; 11) is linked to a rotary distributor (13; 14) which is connected to an outlet line and a feed line (15 and 16 respectively) for a coolant.

2. The apparatus as claimed in claim 1, wherein a pressure regulator (12) is arranged in the feed line (16) to the rotary distributor (14).

3. The apparatus as claimed in claim 1, wherein the rotary distributor (13) to which the outlet line (15) is connected, contains a throttle (17) for regulating the flow of the coolant.

4. The apparatus as claimed in claim 1, wherein the conveyor rollers (4) are arranged in a horizontal plane parallel to one another.

5. The apparatus as claimed in claim 1, wherein the conveyor rollers (4) are arranged on two plate frames (20, 21) in parallel with one another on each plate frame, and wherein the two plate frames (20, 21) whose inclination to each other can be adjusted, form a V-shaped conveyor apparatus (22) with a common axis (26) of rotation.

6. The apparatus as claimed in claim 10, wherein each of the two plate frames (20, 21) can be adjusted with the aid of a pneumatic cylinder (23, 24) which is mounted laterally and virtually vertically on a basic frame (25).

7. The apparatus as claimed in claim 6, wherein the outer end of the piston rod (30, 31) of each of the two pneumatic cylinders (23, 24) is pivotably linked to the bottom side of the associated plate frame (20, 21) at an articulation point (28; 29).

8.  The apparatus as claimed in claim 1, wherein the surfaces of the conveyor rollers (4) are metallic in order to achieve a high heat reflection.

9.  The apparatus as claimed in claim 1, wherein the coolant is air, water, a coolant composed of water, lubricating additive and an additive which delays ageing of the water or an organic solvent.

FIG.1

FIG.2

FIG.3

FIG.4